(19) Europäisches Patentamt
European Patent Office
Office européen des brevets

(11) Publication number: **0 289 191 B1**

(12) **EUROPEAN PATENT SPECIFICATION**

(45) Date of publication of patent specification: **23.12.92**

(51) Int. Cl.5: **G11C 27/04**, G11C 19/00

(21) Application number: **88303509.9**

(22) Date of filing: **19.04.88**

(54) **Signal reading circuit.**

(30) Priority: **30.04.87 JP 104604/87**

(43) Date of publication of application:
**02.11.88 Bulletin 88/44**

(45) Publication of the grant of the patent:
**23.12.92 Bulletin 92/52**

(84) Designated Contracting States:
**DE FR GB IT NL**

(56) References cited:
**EP-A- 0 099 583**
**EP-A- 0 122 081**

(73) Proprietor: **CANON KABUSHIKI KAISHA**
**30-2, 3-chome, Shimomaruko, Ohta-ku**
**Tokyo(JP)**

(72) Inventor: **Hashimoto, Seiji**
**6-2-307, Namiki 2-chome Kanazawa-ku**
**Yokohama-shi Kanagawa-ken(JP)**

(74) Representative: **Beresford, Keith Denis Lewis et al**
**BERESFORD & Co. 2-5 Warwick Court High Holborn**
**London WC1R 5DJ(GB)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

The present invention relates to a signal reading circuit for reading out a signal as a voltage to a signal line through a read transistor and for outputting.

Fig. 1A is a circuit diagram showing an example of a conventional signal reading circuit. Fig. 1B is a timing chart for explaining the operation.

Fig. 1A, by setting a pulse $\phi_t$ to the high level for a predetermined period of time, a transfer transistor $Q_t$ is turned on, so that signals $S_1$, $S_2$, $S_3$, ... of sensors are transferred and accumulated into each capacitor $C_t$. In this state, scan pulses $\phi_{11}$, $\phi_{12}$, ... are successively output from a shift register 102 to sequentially turn on read transistors $Q_s$, thereby reading out the signals $S_1$, $S_2$, $S_3$, ... stored in the capacitors $C_t$ to a signal line 101. However, since the signal line 101 has a capacitance $C_h$, the signals which are obtained by dividing the storage signals $S_1$, $S_2$, $S_3$, ... by the capacitance of the capacitor $C_t$ and the capacitance $C_h$ are read out to the signal line 101.

As shown in Fig. 1B, pulses $\phi_s$, $\phi_1$, and $\phi_2$ are input to the shift registor 102. The shift register 102 then outputs a scan pulse synchronously with the pulse $\phi_1$ by the start pulse $\phi_s$.

The signal read to the signal line 101 is output through an amplifier A. Whenever each signal is output, a reset transistor $Q_r$ is turned on, thereby resetting the signal line 101 to the earth potential. The pulse $\phi_2$ which is input to the shift register 102 is input to a gate electrode of the reset transistor $Q_r$. The circuit elements and sensors shown in Fig. 1A are formed on the same semiconductor substrate.

However, in the conventional example, the noise components by the scan pulses $\phi_{11}$, $\phi_{12}$, ... are added to the signal which is output from the amplifier A. Therefore, when this signal reading circuit is used in e.g., an image pickup apparatus, there is a problem such that those noise components appear as fixed pattern noises. This point will now be explained with reference to a waveform diagram of a signal line voltage $V_0$ in Fig. 1B. The signal components are omitted in the waveform of $V_0$ for convenience of explanation.

First, for a period of time $T_c$ when the pulse $\phi_2$ is at the high level, the reset transistor $Q_r$ is turned on and the voltage $V_0$ of the signal line 101 is set to the earth potential GND. When the pulse $\phi_2$ falls to the low level and the transistor $Q_r$ is turned off, since an overlap capacitance $C_{s2}$ exists, the trailing amount of the pulse $\phi_2$ is capacitively divided by $C_{s2}$ and $C_h$, so that the voltage $V_0$ of the signal line 101 decreases than the earth voltage GND by only the level corresponding to the trailing amount (oscillating component b).

However, the amplitude of the oscillating component b is always constant because it depends on the capacitance $C_{s2}$.

Next, when the scan pulse $\phi_{11}$ input to the transistor $Q_s$ synchronously with the pulse $\phi_1$ (for a period of time $T_t$), since the overlap capacitance $C_s$ of the transistor $Q_s$ exists, the leading amount of the scan pulse $\phi_{11}$ is capacitively divided by $C_s$ and $C_h$, so that the voltage $V_0$ of the signal line 101 increases by only the level of the leading amount (the voltage $V_r$).The trailing amount is also capacitively divided, so that the voltage $V_0$ of the signal line 101 drops by only the level corresponding to the leading amount (voltage $V_t$) (oscillating component a).

In this manner, the sensor signal $S_1$ is read out to the signal line 101 through the read transistor $Q_s$ and output from the amplifier A. Thus, the reset transistor $Q_r$ is again turned on by the pulse $\phi_2$. In a manner similar to the above, the sensor signals $S_2$, $S_3$, ... are sequentially output.

However, the scan pulses $\phi_{11}$, $\phi_{12}$, ... which are output synchronously with the pulses $\phi_1$ are input to the gate of individual read transistor $Q_s$, so that the following problems occur.

That is, the overlap capacitances of the read transistors have a certain variation due to a variation in semiconductor processes.

Therefore, the oscillating components a are not uniform. Assuming that a veriation of the capacitances $C_s$ is $\Delta C_s$, a variation in oscillating components a is

$$\Delta v_n = \Delta C_s \cdot V_\phi/(C_s + C_h)$$

When it is now assumed that

$C_h$ = 5 pF
$C_s$ = 0.02 pF
$\Delta C_s$ = $C_s$ x 0.01
$V_\phi$ = 5 V,

the variation $\Delta v_n$ in oscillating components a becomes $\Delta v_n$ = 0.2 mV. This variation appears as a fixed pattern noise in the vertical direction on the image and causes the picture quality to deteriorate.

### SUMMARY OF THE INVENTION

It is an object of the present invention to provide a signal reading circuit which can solve the foregoing drawbacks in the conventional techniques.

Another object of the invention is to provide a signal reading circuit which can reduce the fixed pattern noises.

To accomplish these objects, according to claim 1, there is provided a signal reading apparatus comprising:

(a) a plurality of signal sources ($S_1$, $S_2$, $S_3$, ...);
(b) a plurality of accumulating means ($C_t$) each of which is provided for each of said signal sources for temporarily holding signals of said plurality of signal lines;
(c) a plurality of switch means ($Q_s$) each of which is provided for each of said accumulating means ($C_t$) for reading out the signals stored in the accumulating means ($C_t$), one end of each of said switch means ($Q_s$) being connected to corresponding one of said accumulating means ($C_t$);
(d) a capacitive load (101) connected commonly to one end of each of said plurality of switch means;
(e) control means (102) for selectively making said plurality of switch means operative, and thereby sequentially leading the signals stored in said accumulating means ($C_t$) to said capacitive load (101);
(f) clearing means ($Q_r$) for clearing the signals led to said capacitive load; and

characterised in that the reading apparatus further comprises

reading means (103) for reading out the signals held in the capacitive load (101) for a period of time after each of said switch means ($Q_s$) was made inoperative by said control means (102) and until the capacitive load (101) is cleared by said clearing means ($Q_r$).

As mentioned above, at the voltage $V_0$ on the signal line shown in Fig. 1B, there is a variation in amplitudes of the oscillating components a due to the read transistors $Q_s$. However, it has been confirmed by the experiments that the change voltage $v_r$ at the leading edge and the change voltage $v_t$ at the trailing edge are almost equal. Thus, the voltage $V_0$ of the signal line 101 before and after the oscillating components a is hardly concerned with the variation in oscillating components a.

Each sensor signal is read out to the signal line 101 by the scan pulse through each read transistor $Q_s$. The signal component remains so long as the signal line 101 is not reset by the reset transistor $Q_r$. That is, the signal component exists on the signal line 101 for the period of time $T_s$ in the diagram.

Therefore, as in the embodiment of the invention, when the signal on the signal line 101 is selected and output after the read transistor $Q_s$ was turned off, the signal can be read out without being influenced by the variation in oscillating components a. Since the amplitudes of the oscillating components b are almost constant, they do not become fixed pattern noises.

The above objects and features of the present invention will become apparent from the following detailed description and the appended claims with reference to the accompanying drawings.

## BRIEF DESCRIPTION OF THE DRAWINGS

Fig. 1A is a circuit diagram showing an example of a conventional signal reading circuit;
Fig. 1B is a timing chart for explaining the operation of this circuit;
Fig. 2A is a schematic constitutional diagram of the first embodiment of a signal reading circuit according to the invention;
Fig. 2B is a timing chart for explaining the operation of the circuit of Fig. 2A;
Fig. 3A is a schematic constitutional diagram of the second embodiment of a signal reading circuit according to the invention;
Fig. 3B is a timing chart for explaining the operation of the circuit of Fig. 3A; and
Fig. 4 is a schematic constitutional diagram of an image pickup apparatus using the first embodiment.

## DETAILED DESCRIPTION OF THE PREFERRED EMBODIMENTS

An embodiment of the present invention will be described in detail hereinbelow with reference to the drawings.

Fig. 2A is a schematic constitutional diagram of the first embodiment of a signal reading circuit according to the present invention. Fig. 2B is a timing chart for explaining the operation of this circuit.

The constitutions of the transfer transistors $Q_t$, accumulating capacitors $C_t$, read transistors $Q_s$, reset transistor $Q_r$, signal line 101, and shift register 102 are as explained in Fig. 1A. The pulses $\phi_1$ and $\phi_2$ and the signal line voltage $V_0$ in Fig. 2B are also as described in Fig. 1B.

In this embodiment, a sample and hold (S/H) circuit 103 is provided as selecting means for the signal line 101 separately from a semiconductor substrate on which sensors are formed. The signal line voltage $V_0$ after the scan pulse fell to the low level is sampled and held and output. That is, in the period of time $T_s$ in Fig. 2B, a pulse $\phi_{sh}$ is given to the S/H circuit 103 for a period of time $T_x$ before it is reset by the pulse $\phi_2$ after the elapse of the period of time $T_t$, thereby holding the signal line voltage $V_0$ at that time. Thus, the influence by the fixed pattern noises due to the transistor $Q_s$ can be prevented.

Fig. 3A is a schematic constitutional diagram of the second embodiment of a signal reading circuit according to the invention. Fig. 3B is a timing chart for explaining the operation of this circuit. The same parts and components as those in the first embodiment are designated by the same reference numerals.

In this embodiment, the S/H circuit 103 consisting of a transistor $Q_{sh}$ is provided on the same semiconductor substrate as the sensors. An inverted pulse $\phi_1$ of a pulse $\overline{\phi_1}$ is given to a gate electrode of the transistor $Q_{sh}$. By forming the transistor $Q_{sh}$ in the sensor, the structure is simplified and the cost can be also reduced.

First, the reset transistor $Q_r$ is turned on by a pulse $\phi_{hc}$, thereby resetting the signal line 101 to the earth potential GND (for the period of time $T_c$). After the elapse of the period of time $T_c$, the pulse $\phi_{hc}$ falls, so that the signal line voltage $V_0$ decreases to a level lower than the earth potential GND as mentioned above (oscillating component b).

The pulse $\phi_1$ rises in response to the trailing edge of the pulse $\phi_{hc}$. The scan pulse $\phi_{11}$ is input from the shift register 102 to the gate electrode of the transistor $Q_s$ synchronously with the leading edge of the pulse $\phi_1$. Simultaneously, the gate electrode of the transistor $Q_{sh}$ is set to the low level and the transistor $Q_{sh}$ is turned off.

Therefore, the read transistor $Q_s$ is turned on for the period of time $T_t$ and the sensor signal $S_1$ is read out to the signal line 101 and held thereon.

Subsequently, after the expiration of the period of time $T_t$, when the pulse $\phi_1$ trails, the transistor $Q_{sh}$ is turned on. The signal existing on the signal line 101 for the period of time $T_s$ is output through the amplifier A. At this time, the signal line 101 includes no variation in oscillating components a due to the scan pulses $\phi_{11}$ as mentioned above.

Then, after the elapse of the period of time $T_s$, the reset pulse $\phi_{hc}$ rises and the reset transistor $Q_r$ is turned on, thereby resetting the signal line 101. The fixed pattern noises are also eliminated with this structure.

Although the reset transistor $Q_r$ has been used to reset the signal line 101 in the embodiment, another reset transistor may be also provided on an output terminal. On the other hand, in place of the pulse $\overline{\phi_1}$, another pulse having a width narrower than the pulse $\overline{\phi_1}$ may be also used.

Fig. 4 is a schematic constitutional diagram of an image pickup apparatus using the first embodiment.

In the diagram, an image pickup device 201 consisting of photosensors arranged in an area form is television scanned by a vertical scan portion 202 and a horizontal scan portion 203.

A signal output from the horizontal scan portion 203 is output as a standard television signal through the S/H circuit 103 and a processing circuit 204.

Drive pulses and the like of the vertical scan portion 202 and horizontal scan portion 203 and the pulse $\phi_{sh}$ and the like of the S/H circuit 103 are supplied by a driver 205. The driver 205 is controlled by a controller 206.

The horizontal scan portion 203 comprises: the transfer transistors $Q_t$, capacitors $C_t$, read transistors $Q_s$, reset transistor $Q_r$, signal line 101, shift register 102, and the like in Fig. 2A.

With the horizontal scan portion 203 and S/H circuit 103, the video signal without the fixed pattern noises as already explained is obtained and the picture quality can be improved.

As described in detail above, the signal reading circuit according to the invention has a simple structure such that there is provided the selecting means for selecting and outputting the signal on the signal line after the read transistor was turned on or off. Therefore, the signal can be taken out without being influenced by the manufacturing variation or the like of the read transistors.

Consequently, when the invention is used in, e.g., the image pickup apparatus, the image of a good quality without the fixed pattern noise can be derived.

## Claims

**1.** A signal reading apparatus comprising:

(a) a plurality of signal sources ($S_1$, $S_2$, $S_3$, ...);

(b) a plurality of accumulating means ($C_t$) each of which is provided for each of said signal sources for temporarily holding signals of said plurality of signal lines;

(c) a plurality of switch means ($Q_s$) each of which is provided for each of said accumulating means ($C_t$) for reading out the signals stored in the accumulating means ($C_t$), one end of each of said switch means ($Q_s$) being connected to corresponding one of said accumulating means ($C_t$);

(d) a capacitive load (101) connected commonly to one end of each of said plurality of switch means;

(e) control means (102) for selectively making said plurality of switch means operative, and thereby sequentially leading the signals stored in said accumulating means ($C_t$) to said capacitive load (101);

(f) clearing means ($Q_r$) for clearing the signals led to said capacitive load; and

characterised in that the reading apparatus further comprises

reading means (103) for reading out the signals held in the capacitive load (101) for a period of time ($T_x$) after each of said switch means ($Q_s$) was made inoperative by said control means (102) and until the capacitive load (101) is cleared by said clearing means ($Q_r$).

2. An apparatus according to claim 1, wherein said accumulating means ($C_t$) includes capacitors.

3. An apparatus according to claim 1, wherein said control means (102) includes a shift register.

4. An apparatus according to claim 1, wherein the timing for selectively making said plurality of switch means ($Q_s$) operative by said control means (102) and the timing for the operation of said clearing means ($Q_r$) are synchronised with each other.

5. An apparatus according to claim 1, wherein said reading means (103) includes sampling and holding means.

6. An apparatus according to claim 1, further including a signal output terminal, and wherein said reading means (103) includes switch means ($Q_{sh}$) arranged between said capacitive load (101) and said signal output terminal.

**Patentansprüche**

1. Signalleseschaltung mit:
(a) einer Vielzahl von Signalquellen ($S_1$, $S_2$, $S_3$, ...);
(b) einer Vielzahl von Akkumuliermitteln ($C_t$), die jeweils für eine der Signalquellen zur Zwischenspeicherung der Signale aus der Vielzahl von Signalleitungen vorgesehen sind;
(c) einer Vielzahl von Schaltmitteln ($Q_s$), die jeweils für eines der Akkumuliermittel ($C_t$) zum Auslesen der in den Akkumuliermitteln ($C_t$) gespeicherten Signale vorgesehen sind, wobei ein Anschluß eines jeweiligen Schaltmittels ($Q_s$) mit einem entsprechenden Anschluß der Akkumuliermittel ($C_t$) verbunden ist;
(d) einer kapazitiven Last (101), die gemeinsam mit einem Anschluß eines jeden aus der Vielzahl von Schaltmitteln verbunden ist;
(e) Steuermitteln (102) zur selektiven Aktivierung der Vielzahl von Schaltmitteln, um dadurch die in den Akkumuliermitteln ($C_t$) gespeicherten Signale sequentiell in die kapazitive Last zu leiten;
(f) Löschmitteln zum Löschen der in die kapazitive Last geleiteten Signale;
dadurch gekennzeichnet, daß die Leseschaltung ferner Lesemittel (103) aufweist zum Auslesen der Signale, die in der kapazitiven Last (101) für eine Zeitdauer (Tx) nach der Inaktivierung jedes der Schaltmittel ($Q_s$) durch die Steuermittel (102) bis zur Löschung der kapazitiven Last (101) durch die Löschmittel ($Q_r$) gespeichert sind.

2. Signalleseschaltung nach Anspruch 1, deren Akkumuliermittel ($C_t$) Kondensatoren aufweisen.

3. Signalleseschaltung nach Anspruch 1, deren Steuermittel (102) ein Schieberegister aufweisen.

4. Signalleseschaltung nach Anspruch 1, deren zeitliche Steuerung zur selektiven Aktivierung der Vielzahl von Schaltmitteln ($Q_s$) durch die Steuermittel (102) mit der zeitlichen Steuerung zur Aktivierung der Löschmittel ($Q_r$) synchronisiert ist.

5. Signalleseschaltung nach Anspruch 1, deren Lesemittel (103) Abtast-Speichereinrichtungen enthalten.

6. Signalleseschaltung nach Anspruch 1, die ferner ein Signalausgabe-Endgerät aufweist, wobei die Lesemittel (103) Schaltmittel ($Q_{sn}$)-aufweisen, die zwischen der kapazitiven Last (101) und dem Signalausgabe-Endgerät angeordnet sind.

**Revendications**

1. Appareil de lecture de signaux comportant :
(a) plusieurs sources de signaux ($S_1$, $S_2$, $S_3$, ...) ;
(b) plusieurs moyens d'accumulation ($C_t$) prévus chacun pour chacune desdites sources de signaux afin de bloquer temporairement des signaux faisant partie de ladite pluralité de lignes de signaux ;
(c) plusieurs moyens de commutation ($Q_s$) prévus chacun pour chacun desdits moyens d'accumulation ($C_t$) afin d'extraire les signaux stockés dans les moyens d'accumulation ($C_t$), une extrémité de chacun desdits moyens de commutation ($Q_s$) étant connectée à l'un, correspondant, desdits moyens d'accumulation ($C_t$) ;
(d) une charge capacitive (101) connectée en commun à une extrémité de chacun desdits moyens de commutation ;
(e) des moyens de commande (102) destinés sélectivement à rendre opérants lesdits moyens de commutation et à conduire ainsi séquentiellement à ladite charge capacitive (101) les signaux stockés dans lesdits moyens d'accumulation ($C_t$) ;
(f) des moyens d'effacement ($Q_r$) destinés à effacer les signaux conduits à ladite charge capacitive ; et

caractérisé en ce que l'appareil de lecture comporte en outre

des moyens de lecture (103) destinés à lire les signaux bloqués dans la charge capacitive (101) pendant une période de temps ($T_x$) après que chacun desdits moyens de commutation ($Q_s$) a été rendu inopérant par lesdits moyens de commande (102) et jusqu'à ce que la charge capacitive (101) soit effacée par lesdits moyens d'effacement ($Q_r$).

**2.** Appareil selon la revendication 1, dans lequel lesdits moyens d'accumulation ($C_t$) comprennent des condensateurs.

**3.** Appareil selon la revendication 1, dans lequel lesdits moyens de commande (102) comprennent un registre à décalage.

**4.** Appareil selon la revendication 1, dans lequel le temps pour rendre opérants sélectivement lesdits moyens de commutation ($Q_s$) par lesdits moyens de commande (102) et le temps pour l'intervention desdits moyens d'effacement ($Q_r$) sont synchronisés entre eux.

**5.** Appareil selon la revendication 1, dans lequel lesdits moyens de lecture (103) comprennent des moyens d'échantillonnage et de bloquage.

**6.** Appareil selon la revendication 1, comprenant en outre une borne de sortie de signaux, et dans lequel lesdits moyens de lecture (103) comprennent des moyens de commutation ($Q_{sh}$) agencés entre ladite charge capacitive (101) et ladite borne de sortie de signaux.

FIG. 1A

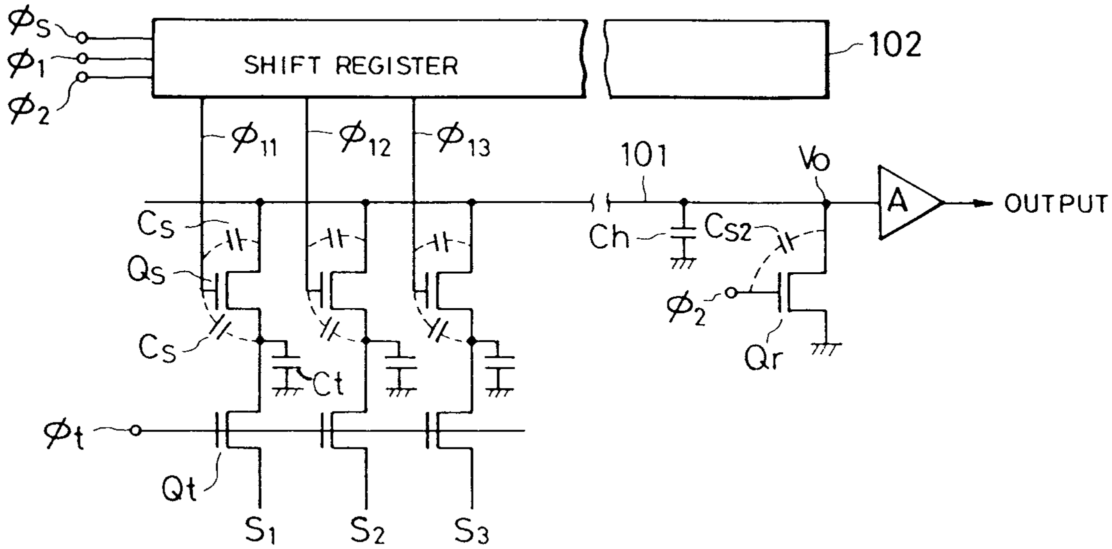
φs
φ1
φ2
SHIFT REGISTER
102
φ11
φ12
φ13
101
Vo
A
OUTPUT
Cs
Qs
Cs
Ct
Ch
Cs2
φ2
Qr
φt
Qt
S1
S2
S3

FIG. 1B

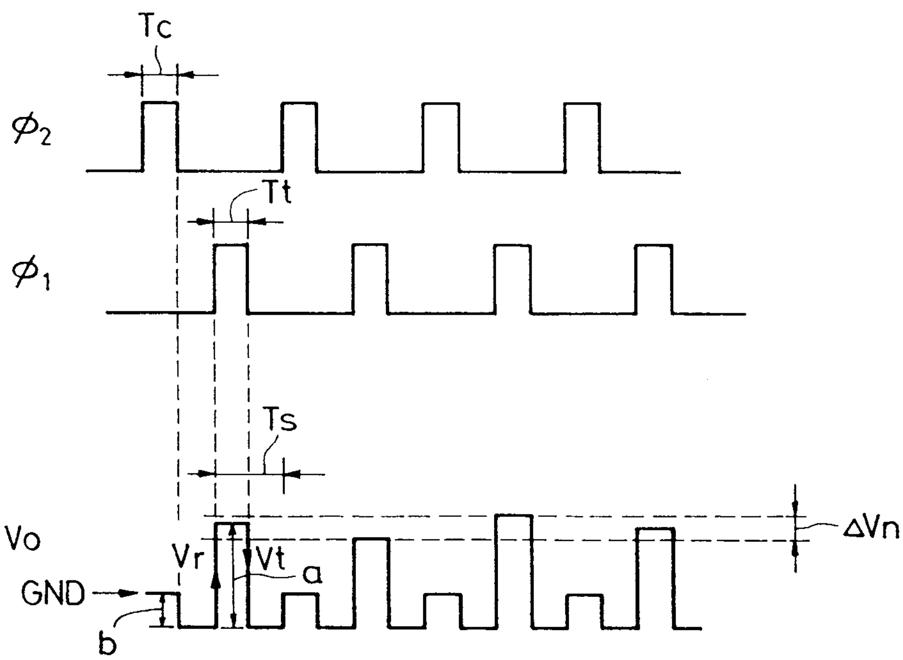
Tc
φ2
Tt
φ1
Ts
Vo
Vr
Vt
a
GND
b
ΔVn

FIG. 2A

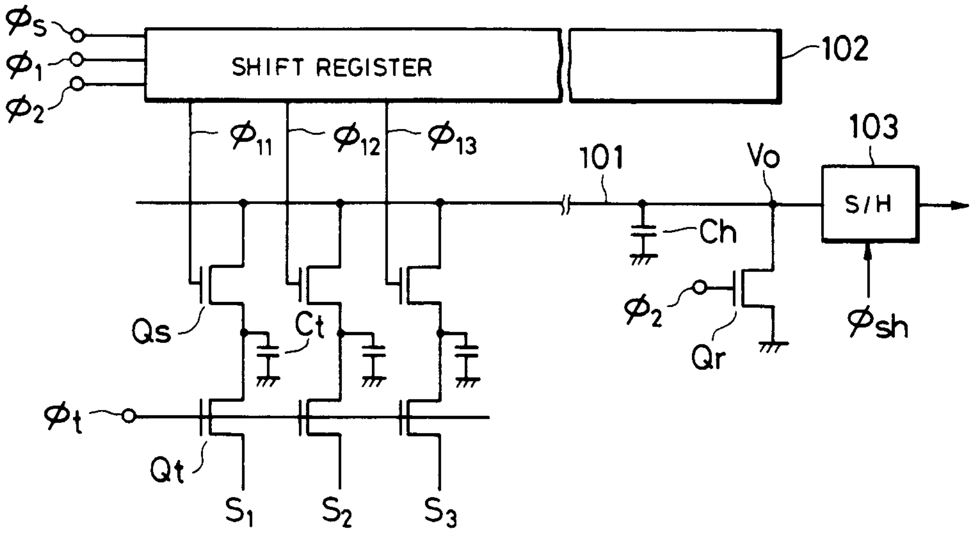
φs
φ1
φ2
SHIFT REGISTER
102
φ11
φ12
φ13
101
Vo
103
S/H
Ch
φ2
Qr
φsh
Qs
Ct
φt
Qt
S1
S2
S3

FIG. 2B

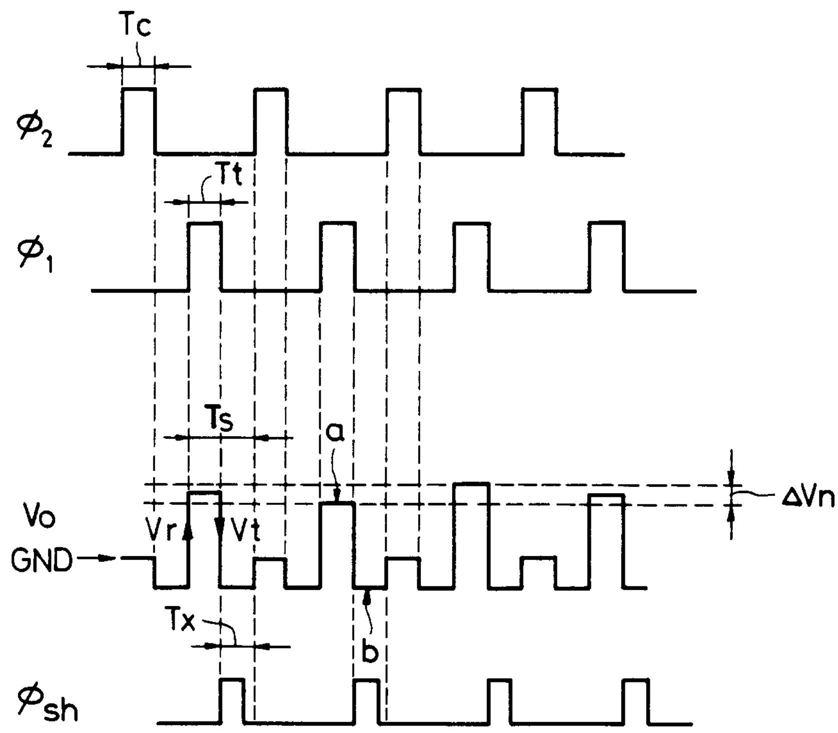
Tc
φ2
Tt
φ1
Ts
a
Vo
GND
Vr
Vt
ΔVn
Tx
b
φsh

FIG. 3A

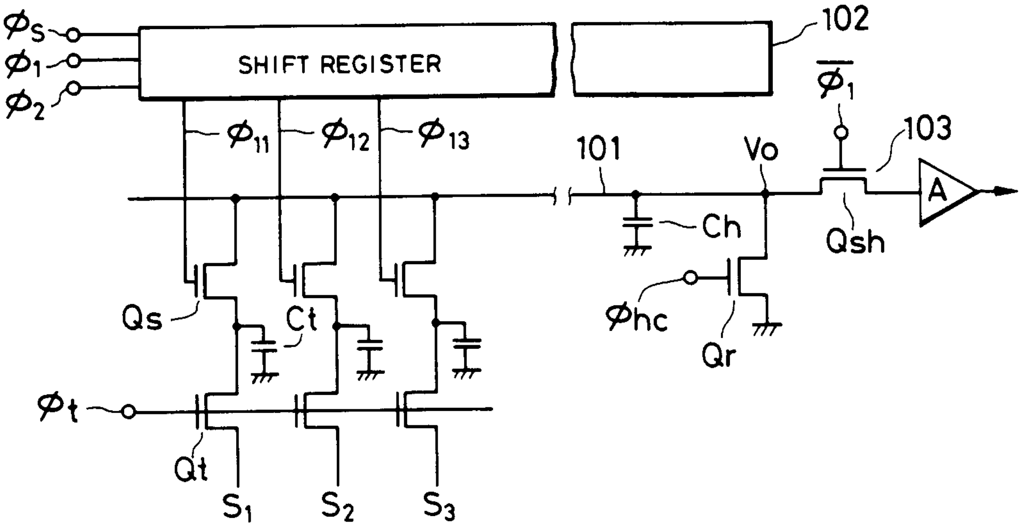
φs
φ1
φ2
SHIFT REGISTER
102
φ̄1
103
φ11
φ12
φ13
101
Vo
Ch
Qsh
A
Qs
Ct
φhc
Qr
φt
Qt
S1
S2
S3

FIG. 3B

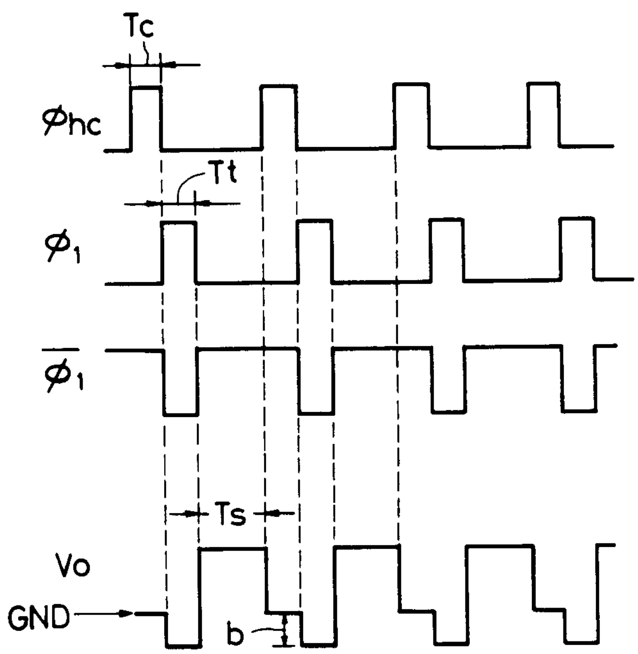
Tc
φhc
Tt
φ1
φ̄1
Ts
Vo
GND
b

FIG. 4

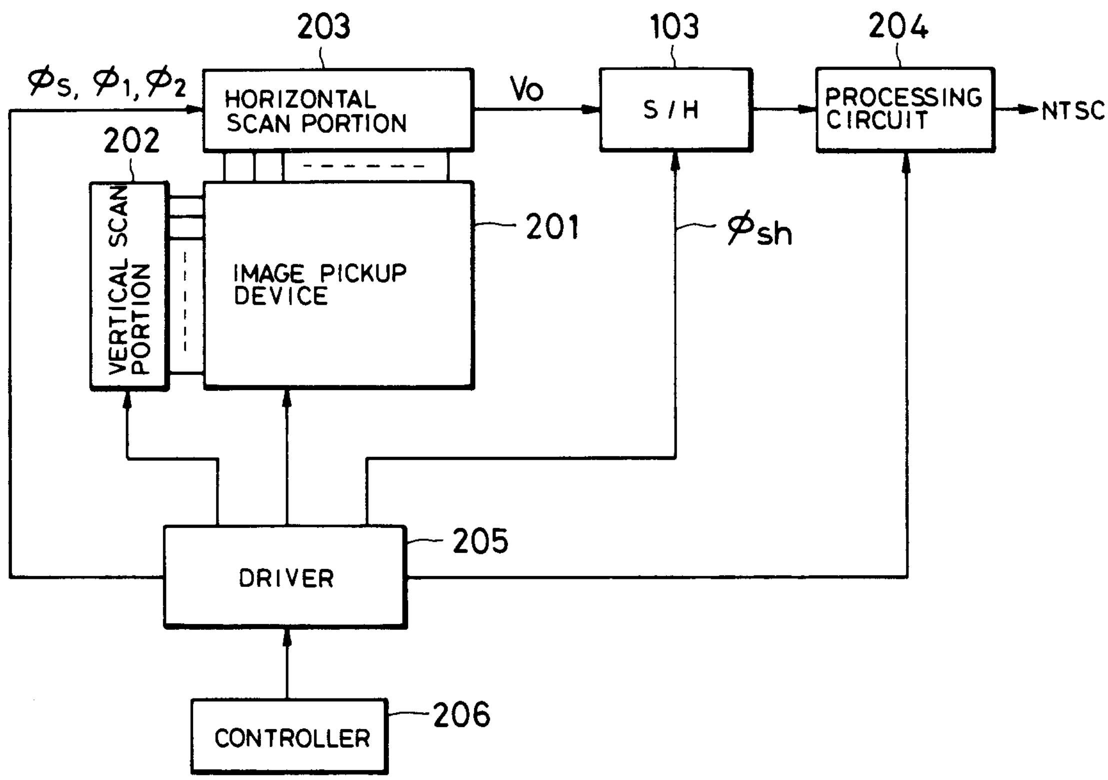

203
103
204
φs, φ1, φ2
HORIZONTAL SCAN PORTION
Vo
S / H
PROCESSING CIRCUIT
NTSC
202
VERTICAL SCAN PORTION
201
φsh
IMAGE PICKUP DEVICE
205
DRIVER
206
CONTROLLER